# EUROPEAN PATENT APPLICATION

(11) **EP 4 814 578 A1**
(43) Date of publication of application: **30.09.2026**
(21) Application number: 25224227.6
(22) Date of filing: 17.12.2025
(51) Int. Cl.: G03F 1/22, G03F 1/24, G03F 1/38, G03F 1/40

(54) **EUV RETICLE WITH CHARGE DISSIPATION STRUCTURE**

(30) Priority: 28.03.2025 US 202519093698
(71) Applicant: Intel Corporation, Santa Clara, CA 95054 (US)
(72) Inventor: TANDON, Shakul, Portland, 97229 (US); PIERCE, Kimberly, Beaverton, 97006 (US); PHILLIPS, Mark, Hillsboro, 97124 (US); KIM, Yongbae, San Jose, 95125 (US); RODRIGUEZ, Robert, Portland, 97229 (US); SINGH, Chetana, Camas, 98607 (US); GARG, Divja, Portland, 97201 (US); MELLOTT, Michael, Hillsboro, 97123 (US); MCCARTY, Benjamin, Portland, 97224 (US); GRUNES, Harsha, Beaverton, 97007 (US)
(74) Representative: 2SPL Patentanwälte PartG mbB

(57) **Abstract**

Provided is a reticle with charge dissipation structures for protecting reflector stack portions that may be part of a black border region of the reticle.

## Description

### BACKGROUND

Many advanced semiconductor integrated circuit devices are made using EUV (Extreme Ultra-Violet) photo lithography processes. These lithography tools use masks (reticles) that are built with a multi-layered stack to perform reflective scan lithography for imaging patterns into the various layers that make up a semiconductor device. EUV masks typically use an opaque ring, called a black border (BB), surrounding a main (or active) device pattern region. The purpose of the black border is to absorb EUV light so that it does not reflect onto adjacent dies on the wafer during patterning. Most EUV masks use black borders formed from an etch process where the multilayer reflective stack is etched away to expose the bottom mask substrate to form a relatively deep, EUV light-absorbing trench, although some may be made using deposition approaches. At the same time, semiconductor chips are typically made with scribe regions disposed around the active semiconductor die region not only to facilitate cutting the dies out of a wafer, but also, to provide metrology and other structures for testing the dies before they are cut away. Unfortunately, these BB trenches can make it more challenging to create the scribe regions with desired metrology structures near them without making the masks susceptible to damage during the lithography process or causing defects to be imparted onto the active die region. This can be especially true with the use of methods where parts of a field are subjected to double exposure, e.g., with overlapping frame techniques where reticle images are step-scanned in an interlocking manner over a wafer until the entire, usable wafer has been scanned. A challenge is that with such schemes, the overlapped areas are double exposed, making it even more difficult to create suitable scribe region structures while using reticles without using these black border trenches. Accordingly, new solutions would be desired.

### BRIEF DESCRIPTION OF THE DRAWINGS

The disclosure may best be understood by referring to the following description and accompanying drawings that are used to illustrate embodiments. In the drawings:
FIG. 1 is a diagram depicting an EUV scan system for fabricating integrated circuit semiconductor dies in accordance with some embodiments.
FIG. 2 is a diagram showing a side cross-sectional schematic view of an exemplary EUV reticle.
FIG. 3A is a diagram schematically showing a layout (top view) for an exemplary EUV reticle.
FIG. 3B is a diagram showing a side cross-sectional schematic view of the reticle of Fig. 3A taken along line 3B-3B.
FIG. 3C is a conceptual view illustrating over-lapping exposures for an interlocking step scan process using the reticle of Figs. 3A-3B.
FIG. 4A is a diagram illustrating an observed destructive charge vulnerability for the reticle layout of Fig. 3A.
FIG. 4B is a diagram showing a side cross-sectional schematic view of the reticle of Fig. 4A taken along line 4B-4B.
FIG. 5A is a diagram showing the reticle layout of Fig. 3A including charge dissipation (CD) cell structures in accordance with some embodiments.
FIG. 5B is a diagram showing a side cross-sectional schematic view of the reticle of Fig. 5A taken along line 5B-5B.
FIGS. 6A-6C are schematic diagrams showing a CD unit cell and cell array structures in accordance with some embodiments.
FIGS. 7A-7C are schematic diagrams showing a CD unit cell and cell array structures in accordance with some additional embodiments.

### DETAILED DESCRIPTION

With some implementations, it is desirable to be able to make scribe region structures that correspond to areas of the reticle that are in a black border region. To achieve this, isolated multi-layer reticle stack structures disposed within the black border may be employed. Unfortunately, it has been observed that such isolated reticle structures can build up electrical charge while the reticle is used in a scanning operation. The charge can then discharge onto other parts of the reticle, causing catastrophic damage. In some embodiments, a solution is provided to prevent such discharge (arching) by providing a discharge path between, for example, the isolated multilayer region(s) and the active device region of the reticle.

Extreme ultraviolet (EUV) lithography is an optical lithography technology used in semiconductor device fabrication to make integrated circuits (ICs). Currently, it uses extreme ultraviolet (EUV) wavelengths near 13.5 nm, typically using a laser-pulsed tin (Sn) droplet plasma to produce a pattern by using a reflective photomask (e.g., reticle) to expose targeted photoresist on a semiconductor wafer.

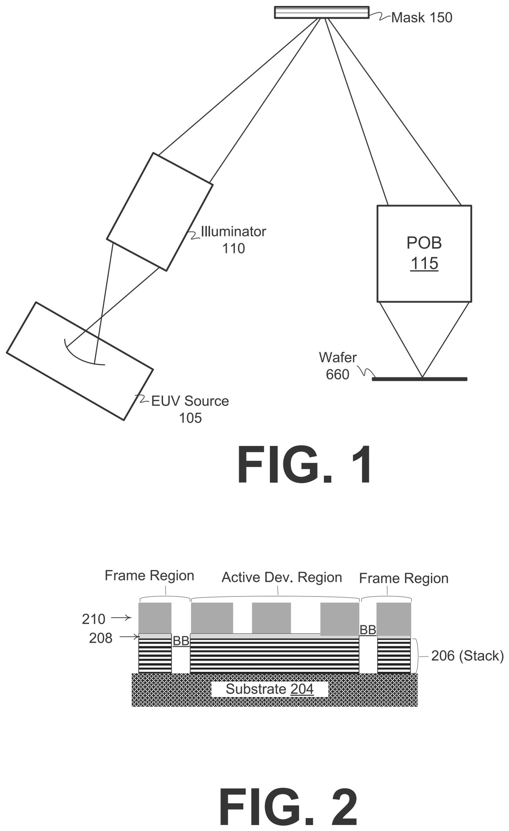

Fig. 1 is a schematic diagram depicting an EUV scan system for fabricating integrated circuit semiconductor dies in accordance with some embodiments. The system generally includes an EUV source 105, an illuminator 110, and a projection optics box (POB) 115 for lithographically scanning nano-order features into a semiconductor wafer 160 using a reticle 150 as indicated.

The EUV source 105 generates EUV radiation provided to the illuminator 110, which forms a pupil shape to illuminate the right amount of light for the EUV reticle 150. The reticle reflects the EUV radiation in accordance with feature patterns defined within the mask's reflector layer stack. The reflected EUV pattern is then imaged onto a portion of the wafer through the POB. From here, the wafer is moved to a new position, and the process is repeated. In this way, nano-scale "cuts" can be applied to the wafer to define nano-feature elements such as fins, gates, metal lines, and the like.

Fig. 2 is a diagram showing a side cross-sectional schematic view of an exemplary EUV reticle positioned with its beam contacting surface facing upward, flipped from the mask of Fig. 1. The EUV reticle is a sophisticated multi-layer film stack generally including multiple reflector layers 206 disposed atop a low thermal expansion material (LTEM) substrate (e.g., glass) 204. It also includes a cap layer (e.g., Ruthenium) 208 disposed atop the reflector layers 206, and an EUV absorption layer 210 disposed above the cap layer 208. (Note that the term "atop" is relative in that it connotes a relative position of a layer within a stack of multiple layers, but in absolute terms, a layer that is "atop" another layer may actually be below, above, sideways, etc. to the other layer, depending on the position of the stack in absolute space relative to the utilized spatial reference.)

As indicated in the figure, the multilayer reflector stack, cap, and absorber layers can generally be divided into an active device region and a surrounding frame region. The active device region corresponds to the active semiconductor IC to be patterned into the die. Among other things, the frame region corresponds to the scribe line regions that will surround the die. The frame regions of the reticle can also include the black border (BB), e.g., BB trenches, as illustrated in this diagram. (Note that for convenience, the term, "reticle stack", or simply "stack", may be used to refer to most if not all the working layers of a reticle including the reflector, cap and absorber layers and it is not intended, depending on context, to be limited to just the multi-layer reflector stack.)

The reflector layers 206 typically include between 40 and 50 alternating layers of silicon and molybdenum deposited on the LTEM substrate 204 to act as a Bragg reflector that maximizes the reflection of the EUV wavelength. The multi-layer reflector 206 is capped with the cap layer 208 to prevent oxidation and as an etch stopping layer against the plasma etch process that forms patterns of the absorber layer 210, typically using a thin layer of ruthenium. The absorption layer (or absorber) 210, which functions as part of a reticle's incident scan surface, serves to absorb the EUV radiation in areas where features are, or are not, to occur, depending on the particular lithography being implemented. In some configurations, absorber layer patterns may be implemented with a tantalum boron nitride film or a tantalum nitride topped with a thin anti-reflective material.

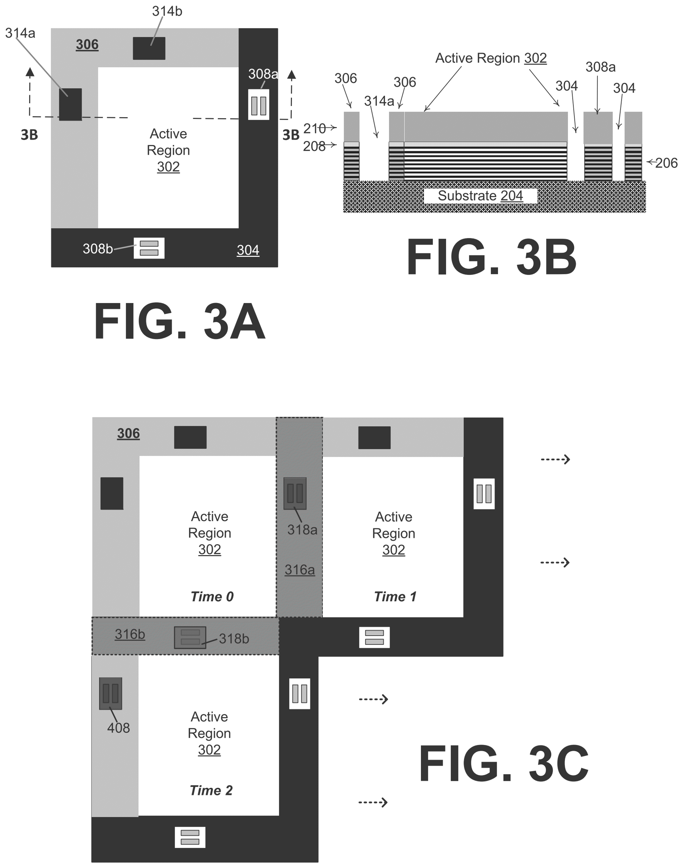

Reference is made to Figures 3A and 3B. Figure 3A is a diagram schematically illustrating a top view of an exemplary EUV mask reticle layout, and Fig. 3B is a diagram showing a side cross-sectional schematic view of the reticle of Fig. 3A taken along line 3B-3B.

The reticle includes an active stack region (or simply active region) 302 and a frame surrounding the active region that includes a black border section 304 and a reflector section 306. The reflector section exposes a corresponding scribe region of the wafer portion being scanned. It includes reticle stack structure that may be configured similarly, or the same, as the reticle stack layers used for the active region of the reticle.

While the black border section 304 mostly includes black border trench space, it also includes reticle stack portions (e.g., islands) 308a, 308b that are substantially, if not completely, surrounded by black border space. Likewise, while the frame reflector section 306 is mostly made up of reticle stack structure, it also includes black border portions 314a, 314b that correspond to the reticle stack portions 308a, 308b, respectively. The reticle stack portions 308a, 308b are used to pattern metrological features (e.g., test, alignment) into corresponding cells (referred to herein as metrology cells,) of wafer scribe line regions.

The reticle stack portions may be better suited for creating metrology cells, which can include finely patterned features that may be tightly spaced together. The reflecting stack structures of the reflector section 306, on the other hand, may not be useful for precise, detailed patterning due to certain optics and design rule limitations. They instead may be used for layer fil and/or for course scribe region structures. On the other hand, the reticle stack portions 308 may be better suited for such patterning since they are surrounded by black border space that can effectively absorb unwanted EUV radiation and enhance optical control. As will be explained below, the black border portions 314 are used to protect the reticle stack portions when they would otherwise be subjected to a second EUV exposure during an interlocking step scan process.

Figure 3C is a conceptual view illustrating over-lapping exposures for an interlocking step scan process using the reticle of Figs. 3A-3B. in a step and scan (or simply step scan) process, reticle scan frames on a wafer partially overlap to form an interlocking pattern that comes together to form fields on the wafer.

With this example, the wafer moves right to left, as well as upward once a scan line has completed. Thus, for purposes of explanation, the frame can be thought of as moving left to right, as well as downward when a scan line has completed. The figure shows how exposures from two adjacent fields partially overlap to form an interlocking pattern that comes together to form fields on the wafer. The overlapping regions are shown at 316a, 316b.

It can be seen that the frame black border portion 314a from Time 1 overlaps with the reticle stack portion 308a from Time 0. Similarly, the black border portion 314b from Time 2 overlaps with the reticle stack portion 308b from Time 0. These areas of alignment are illustrated at 318a, 318b, respectively. It can be seen that in this way, metrological pockets may be formed in each of the scribe region sides of an active field region. It also may be noted that each of these scribe region sides is also subjected to double EUV exposure, which can affect what types of features or structures may be allowed for the parts of the frame that are not shielded from double exposure by the black border portions.

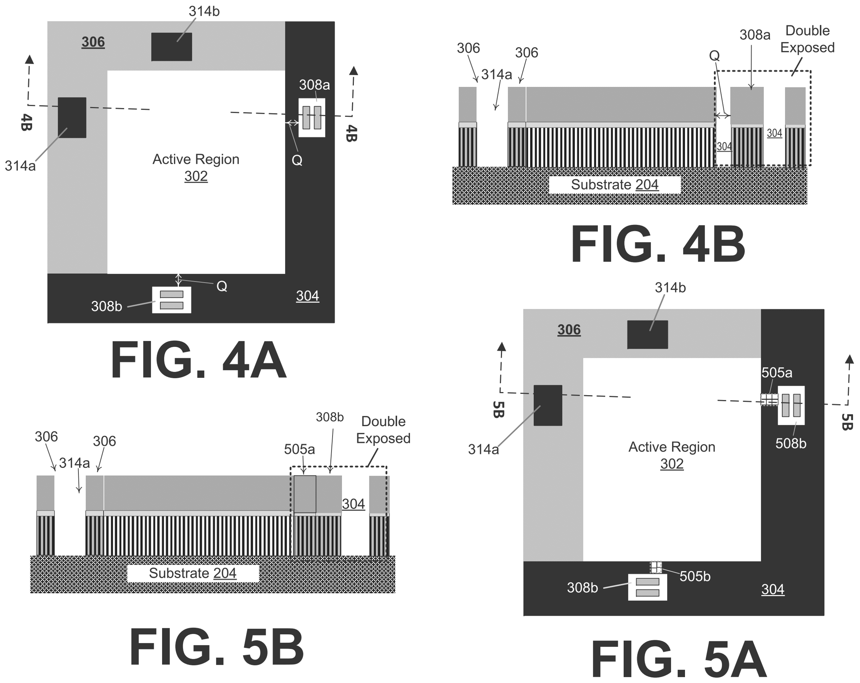

Reference is now made to Figures 4A and 4B. Fig. 4A is a diagram illustrating an observed destructive charge vulnerability for the reticle layout of Fig. 3A. Fig. 4B is a diagram showing a side cross-sectional schematic view of the reticle of Fig. 4A taken along line 4B-4B.

The reticle stack portions 308 are susceptible to electro static discharge (charge arching), in this example, from an island to the active region or from the active region to an island. This is illustrated by the "Q" reference in the figures. In other designs, for example, if multiple islands spaced closely together were used, they too could be vulnerable to charge arching between the islands themselves.

Since the reticle stack portions are surrounded (fully in this example) by a black border, electric charge can often build up and potentially cause an arching event. Among other reasons, this can occur as a result of the scanning radiation generating charge onto the islands but not within the black border. When enough charge accumulates, arching can occur, especially when the islands are close enough to an active region or another island.

Reference is now made to Figures 5A and 5B. Fig. 5A is a diagram showing the reticle layout of Fig. 3A including charge dissipation cell (CDC) structures in accordance with some embodiments. Fig. 5B is a diagram showing a side cross-sectional schematic view of the reticle of Fig. 5A taken along line 5B-5B.

In some embodiments, frame design cells are used to implement a pattern 505 (e.g., array) of charge dissipation cells (CDCs) to connect the reticle stack portions to the active region 302. In this way, a conduction path may be provided between two regions of reticle stack structures that are close to each other and separated by black border spaces.

In some embodiments, frame design cells for existing reticle frame design processes may be used for implementing a CDC structure. CDC (charge dissipation cell) units, in conformance with already utilized frame cell rules, may be used to create CDC structures to provide adequate discharge pathways without having to adjust or work outside of existing frame design metrology/scribe structure rules.

In this way, charge buildup can be prevented from occurring by providing a charge dissipation path away from these islands by creating a continuous cell pattern that connects the islands to either other bigger islands or to the active stack region.

A consideration for configuring these CDC structures is that they could overlap with an absorber region from the equivalent opposite scribe region. Unlike black borders that allow very little reflectivity, absorber regions may allow significant reflectivity that can cause patterns in the charge dissipation path to get overexposed, cause defect issues. In some embodiments, to address this concern, a reticle stack cell (e.g., a full reticle stack cell) specifically designed to withstand large process variations may be used. In addition, with the use of frame design cells in this way, designs may be made to be repeatable, making them capable of placement in a variety of different orientations and scalable for tiling to provide discharge per area while being efficient for frame design.

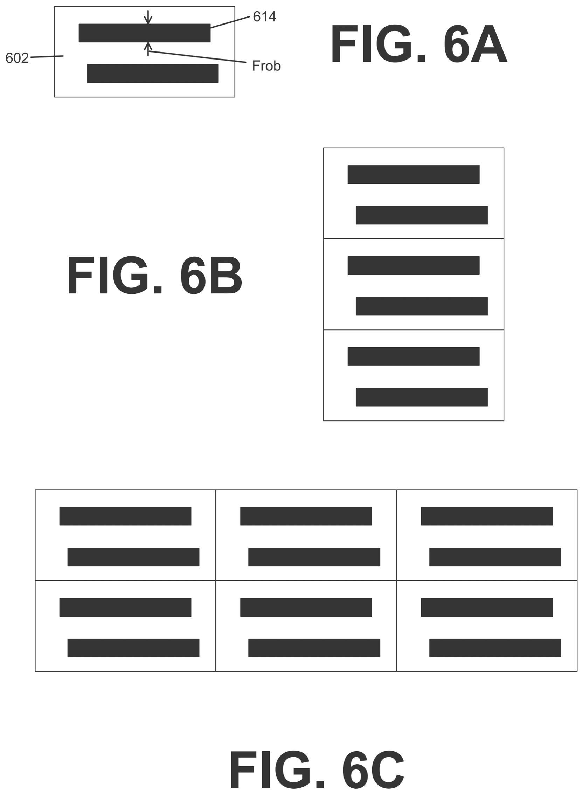

Figs. 6A-6C are schematic diagrams showing exemplary charge dissipation (CD) unit cell and cell structure configurations in accordance with some embodiments. Fig. 6A shows a CD cell 602 with stack features 604, two stack features in this example. The features correspond to a surface of a reticle stack without absorber so as to pattern the feature onto a wafer surface. The white area in the background of the features corresponds to absorber material. The feature has a feature dimension (Frob) with adequate separation between features to provide a robust structure, even when subjected to multiple exposure from the interlocked step-scan process. It is important that the features, as patterned onto a wafer, are resilient enough not to break away and contaminate, or otherwise damage, another part of a wafer.

That is, using larger feature sizes that are more isolated from each other are less, if at all, susceptible to defects. Using a full reticle stack allows for the occupied black border space to be reduced. Further, with such cell structure (e.g, unit cell structure), two or more cells may be tiled in any direction, thus allowing flexibility in creating a charge dissipation channel of almost any dimension (length, width, orientation). This is illustrated with the CD cell unit structures of Figs. 6B-6C.

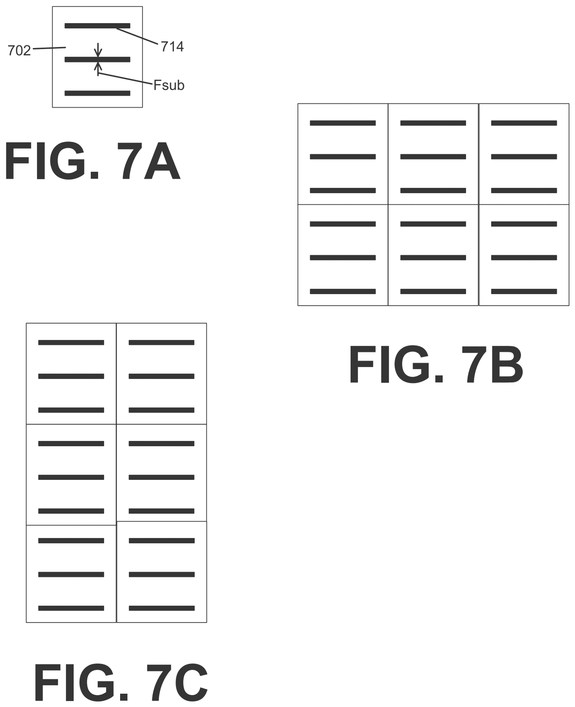

Figs. 7A-7C are schematic diagrams showing a CD unit cell and unit cell array structures in accordance with some additional embodiments. Fig. 7A shows a CD cell 702 with features 714 having sub-resolution feature dimensions (Fsub). The features are disposed on the reticle, but they are too small to be patterned onto a wafer. That is, the feature structures will not print on the wafer so they cannot cause wafer defects during double exposure.

Illustrative examples of the technologies disclosed herein are provided below. An embodiment of the technologies may include any one or more, and any compatible combination of, the examples described below.

Example 1 is a reticle apparatus that includes an active stack region and a frame region. The frame region includes a reticle stack section and a black border section. The black border section includes a reticle stack portion, and the reticle stack section includes a corresponding black border portion. The black border section includes a charge dissipation (CD) structure coupled between the reticle stack portion and the active stack region.

Example 2 includes the subject matter of example 1, and wherein the reticle stack portion is connected to the active stack region through the CD structure.

Example 3 includes the subject matter of any of examples 1-2, and wherein the CD structure includes two or more CD cells.

Example 4 includes the subject matter of any of examples 1-3, and wherein the CD cells are configured into an array of CD cells.

Example 5 includes the subject matter of any of examples 1-4, and wherein the CD cells are unit cells each having the same configuration.

Example 6 includes the subject matter of any of examples 1-5, and wherein the cells include one or more features that are large enough to avoid defect distribution on a wafer to be printed.

Example 7 includes the subject matter of any of examples 1-6, and wherein the cells include one or more features that are too small to be printed onto a wafer.

Example 8 includes the subject matter of any of examples 1-7, and wherein the cells comply with frame design rules used for designing the frame section.

Example 9 includes the subject matter of any of examples 1-8, and wherein the frame section is configured for an interlocking step scan process.

Example 10 is a method of fabricating an integrated circuit wafer. The method includes: reflectively scanning from a reticle a reticle pattern onto a first field of the wafer, the field including an active region and a scribe region that includes a metrology cell, wherein the metrology cell is scanned from a reticle stack portion of the reticle, the reticle stack portion being within a black border trench and being coupled to an active stack region of the reticle through a charge dissipation (CD) structure; and reflectively scanning from the reticle the reticle pattern onto a second field of the wafer, wherein the reticle pattern includes an unexposed portion that overlaps with the metrology cell.

Example 11 includes the subject matter of example 10, and wherein the reticle includes a frame region that includes a reticle stack section and the black border trench, the reticle stack section including a corresponding black border portion that corresponds to the unexposed pattern portion of the second scanned filed.

Example 12 includes the subject matter of any of examples 10-11, and wherein the reticle stack portion is connected to the active stack region directly through the CD structure.

Example 13 includes the subject matter of any of examples 10-12, and wherein the CD structure includes two or more CD cells.

Example 14 includes the subject matter of any of examples 10-13, and wherein the CD cells are configured into an array of CD cells.

Example 15 includes the subject matter of any of examples 10-14, and wherein the CD cells are unit cells each having the same configuration.

Example 16 includes the subject matter of any of examples 10-15, and wherein the cells include one or more features that are large enough to avoid defect distribution on the wafer.

Example 17 includes the subject matter of any of examples 10-16, and wherein the cells include one or more features that are too small to be printed onto the wafer.

Example 18 includes the subject matter of any of examples 10-17, and wherein the cells comply with frame design rules used for designing the frame section.

Example 19 is a system. The system includes: an extreme ultra-violet (EUV) reticle that includes an active stack region, and a frame region that includes a reticle stack section and a black border section, the black border section including a reticle stack portion, and the reticle stack section including a corresponding black border portion, wherein the black border section includes a charge dissipation (CD) structure coupled between the reticle stack portion and the active stack region. The system also includes an EUV radiation source, an illuminator to illuminate the EUV radiation onto the reticle, and a wafer platform to support a semiconductor wafer to be scanned with radiation reflected from the reticle.

Example 20 includes the subject matter of example 19, and wherein the reticle stack portion is connected to the active stack region through the CD structure.

Example 21 includes the subject matter of any of examples 19-20, and wherein the CD structure includes two or more CD cells.

Example 22 includes the subject matter of any of examples 19-21, and wherein the CD cells are configured into an array of CD cells.

Example 23 includes the subject matter of any of examples 19-22, and wherein the CD cells are unit cells each having the same configuration.

Example 24 includes the subject matter of any of examples 19-23, and wherein the cells includes one or more features that are large enough to avoid defect distribution on a wafer to be printed.

Example 25 includes the subject matter of any of examples 19-24, and wherein the cells include one or more features that are too small to be printed onto a wafer.

Example 26 includes the subject matter of any of examples 19-25, and wherein the cells comply with frame design rules used for designing the frame section.

Example 27 includes the subject matter of any of examples 19-26, and wherein the frame section is configured for an interlocking step scan process.

As used in this specification, the term "embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Throughout the specification, and in the claims, the term "connected" means a direct connection, such as electrical, mechanical, or magnetic connection between the things that are connected, without any intermediary devices.

The term "coupled" means a direct or indirect connection, such as a direct electrical, mechanical, or magnetic connection between the things that are connected or an indirect connection, through one or more passive or active intermediary devices.

The terms "substantially," "close," "approximately," "near," and "about," generally refer to being within +/-10% of a target value.

Unless otherwise specified the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

It is pointed out that those elements of the figures having the same reference numbers (or names) as the elements of any other figure can operate or function in any manner similar to that described but are not limited to such.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

The foregoing has outlined features of several embodiments so that those skilled in the art may better understand the detailed description that follows. Those skilled in the art should appreciate that they may readily use the present disclosure as a basis for designing or modifying other processes and structures for carrying out the same purposes and/or achieving the same advantages of the embodiments disclosed herein. Those skilled in the art should also realize that such equivalent constructions do not depart from the spirit and scope of the present disclosure, and that they may make various changes, substitutions, and alterations herein without departing from the spirit and scope of the present disclosure. For example, the methods and reticles disclosed herein may be applicable to other pattern split methods currently available in DPL technology or pattern split methods available in future developed patterning processes that utilize multiple photomasks. Further, the methods and photomasks disclosed herein may be utilized in other types of lithography apparatuses such as an immersion lithography apparatus.

## Claims

1. A reticle apparatus, comprising:
an active stack region; and
a frame region that includes a reticle stack section and a black border section, the black border section including a reticle stack portion, and the reticle stack section including a corresponding black border portion, wherein the black border section includes a charge dissipation (CD) structure coupled between the reticle stack portion and the active stack region.

2. The apparatus of claim 1, wherein the reticle stack portion is connected to the active stack region through the CD structure.

3. The apparatus of claim 1 or 2, wherein the CD structure includes two or more CD cells.

4. The apparatus of claim 3, wherein the CD cells are configured into an array of CD cells.

5. The apparatus of claim 4, wherein the CD cells are unit cells each having the same configuration.

6. The apparatus of one of the previous claims, wherein the cells include one or more features that are large enough to avoid defect distribution on a wafer to be printed.

7. The apparatus of one of the previous claims, wherein the cells include one or more features that are too small to be printed onto a wafer.

8. The apparatus of one of the previous claims, wherein the cells comply with frame design rules used for designing the frame section.

9. The apparatus of one of the previous claims, wherein the frame section is configured for a non-interlocking step scan process.

10. A method of fabricating an integrated circuit wafer, comprising:
reflectively scanning from a reticle a reticle pattern onto a first field of the wafer, the field including an active region and a scribe region that includes a metrology cell, wherein the metrology cell is scanned from a reticle stack portion of the reticle, the reticle stack portion being within a black border trench and being coupled to an active stack region of the reticle through a charge dissipation (CD) structure; and
reflectively scanning from the reticle the reticle pattern onto a second field of the wafer, wherein the reticle pattern includes an unexposed portion that overlaps with the metrology cell.

11. The method of claim 10, wherein the reticle includes a frame region that includes a reticle stack section and the black border trench, the reticle stack section including a corresponding black border portion that corresponds to the unexposed pattern portion of the second scanned field.

12. The method of claim 10 or 11, wherein the reticle stack portion is connected to the active stack region directly through the CD structure.

13. The method of claim 10, 11 or 12, wherein the CD structure includes two or more CD cells.

14. The method of claim 13, wherein the CD cells are configured into an array of CD cells.

15. A system, comprising:
an extreme ultra-violet (EUV) reticle that includes:
an active stack region; and
a frame region that includes a reticle stack section and a black border section, the black border section including a reticle stack portion, and the reticle stack section including a corresponding black border portion, wherein the black border section includes a charge dissipation (CD) structure coupled between the reticle stack portion and the active stack region;
an EUV radiation source;
an illuminator to illuminate the EUV radiation onto the reticle; and
a wafer platform to support a semiconductor wafer to be scanned with radiation reflected from the reticle.
